# FASCICULE DE BREVET EUROPEEN

(11) **EP 3 036 059 B1**
(45) Date de publication et mention de la délivrance du brevet: **04.10.2017**
(21) Numéro de dépôt: 14786964.8
(22) Date de dépôt: 18.08.2014
(51) Int. Cl.: B23K 1/00, B23K 1/20, F01D 9/04

(54) **PROCEDE D'ASSEMBLAGE DE DEUX PALES D'UN DISTRIBUTEUR DE TURBOMACHINE PAR ALUMINISATION EN PHASE VAPEUR**
VERFAHREN ZUR MONTAGE ZWEIER SCHAUFELN EINER TURBOMASCHINENDÜSE
METHOD FOR ASSEMBLING TWO BLADES OF A TURBOMACHINE NOZZLE

(30) Priorité: 20.08.2013 FR 1358083
(43) Date de publication de la demande: 29.06.2016
(73) Titulaire: SNECMA, 75015 Paris (FR)
(72) Inventeur: BILHE, Pascal, F-77550 Moissy Cramayel Cedex (FR); PASQUET, Annie, F-77550 Moissy-cramayel Cedex (FR)
(74) Mandataire: Cabinet Camus Lebkiri
(86) Numéro de dépôt international: PCT/FR2014/052097
(87) Numéro de publication internationale: WO 2015/025105

(56) Documents cités:
- EP-A2- 2 484 475
- DE-A1- 10 238 551
- FR-A1- 2 950 364
- GB-A- 2 133 104
- JP-A- S6 076 292
- JP-A- 2003 105 458

## Description

### DOMAINE TECHNIQUE DE L'INVENTION

L'invention se rapporte au domaine général de l'aéronautique. Elle concerne les procédés de fabrication des aubes de distributeurs, et plus particulièrement un procédé d'assemblage de deux pâles de distributeur de turbomachine conformément au préambule de la revendication 1 (voir, par exemple, EP2 484 475 A2).

### ARRIERE PLAN TECHNOLOGIQUE DE L'INVENTION

Le savoir-faire actuel en fonderie ne permet pas d'obtenir un distributeur monobloc monocristallin. Ainsi, il est classique d'assembler deux pâles coulées séparément pour former un distributeur. L'assemblage est généralement réalisé par un procédé de brasage-diffusion, qui est le procédé le plus largement utilisé pour l'assemblage de pièces en superalliage.

La technique de brasage-diffusion consiste à assembler des pièces, généralement métalliques, à l'aide d'un métal d'apport, sous forme de poudre ou de feuillard, placé entre les pièces à réunir. La température de fusion du métal d'apport est inférieure à celle des pièces à réunir. Une première étape, dite brasage, consiste à soumettre les pièces et le métal d'apport à une température de brasage. La température de brasage est déterminée de sorte à être inférieure à la température de fusion des pièces à réunir. L'augmentation de température pour atteindre la température de brasage est réalisée par paliers. Les pièces et le métal d'apport sont ensuite maintenus à la température de brasage pendant quelques dizaines de minutes. Durant le brasage, une diffusion atomique s'opère dans une zone formant un joint brasé liant les deux pièces. Une deuxième étape, dite diffusion, consiste à réaliser un traitement thermique de diffusion dans un four, sous atmosphère contrôlée pendant quelques heures, de manière à assurer une homogénéisation suffisante de la matière située au niveau du joint brasé.

Compte tenu des conditions thermodynamiques sévères auxquelles sont soumises les pièces d'une turbomachine en fonctionnement, le métal d'apport le plus adapté pour assembler deux pâles est de composition NiCoSiB1060. La particularité de ce métal d'apport est de comporter du silicium et du bore qui garantissent une bonne liaison chimique entre les pâles à assembler.

Cependant, un défaut majeur de ce composant est la formation de zones de faibles résistances mécanique et environnementale. On entend par résistance environnementale, la capacité à résister à l'oxydation et la corrosion. Or, ce type d'endommagement à la fois mécanique et environnemental est très préjudiciable, engendrant une dégradation accélérée du joint brasé et conduisant au désassemblage des deux pâles.

La rupture est généralement localisée à moins de un millimètre du joint brasé, mais rarement sur le joint. Cette localisation est liée aux phénomènes diffusionnels de part et d'autre du joint, pouvant dépasser une centaines de microns. La diffusion est notamment exacerbée lorsque le superalliage constituant les pâles présente des joints de grains, comme c'est le cas des superalliages polycristallins.

### DESCRIPTION GENERALE DE L'INVENTION

L'invention offre une solution aux problèmes évoqués précédemment, en proposant un procédé d'assemblage de deux pâles, évitant la formation de zones de faibles résistances mécanique et environnementale.

L'invention concerne donc essentiellement un procédé d'assemblage de deux pâles de distributeur de turbomachine tel que défini dans la revendication 1.

Le procédé selon l'invention comporte une étape d'aluminisation. La technique d'aluminisation est couramment utilisée pour protéger des pièces de l'oxydation. Cette technique est bien connue, on pourra en particulier se référer au document FR1433497. Il consiste à placer la pièce à protéger dans une enceinte dans laquelle circule un mélange gazeux comprenant un composé de l'aluminium, tel qu'un halogénure, et un gaz de dilution ou gaz porteur. L'halogénure est produit par réaction entre un halogène, par exemple du chlore ou du fluor, et un donneur métallique contenant de l'aluminium, par exemple un alliage métallique d'aluminium avec un ou plusieurs des constituants métalliques du matériau de la pièce à protéger. Le gaz vecteur assure la dilution et l'entraînement du mélange gazeux pour amener l'halogénure au contact de la pièce afin de former un dépôt, un revêtement, à la surface de celle-ci. Le revêtement formé a la particularité de protéger de l'oxydation. On note que le gaz vecteur couramment utilisé est l'argon.

Lors de l'étape d'aluminisation se forme un dépôt homogène d'aluminium sur la première pâle et sur la deuxième pâle, et notamment sur la première surface et sur la deuxième surface. A la fin de l'étape d'aluminisation, le jeu d'assemblage initial est comblé par ces dépôts.

Le procédé selon l'invention permet donc un accrochage chimique entre les pâles, s'affranchissant de l'utilisation d'un métal d'apport comportant du silicium ou du bore. Ainsi, la formation de zones de faibles résistances mécanique et environnementale, due au bore ou au silicium, est évitée.

De plus, un avantage supplémentaire est retiré du procédé selon l'invention : à la fin de l'étape d'aluminisation, le distributeur formé des deux pâles assemblées est recouvert d'un revêtement antioxydant.

Outre les caractéristiques qui viennent d'être évoquées dans le paragraphe précédent, le procédé selon l'invention peut présenter une ou plusieurs caractéristiques complémentaires parmi les suivantes, considérées individuellement ou selon toutes les combinaisons techniquement possibles.

Conformément à l'invention, le procédé comporte une étape d'implantation de billes soudées dans les première surface et deuxième surface, de sorte à maintenir le positionnement, entre l'étape de positionnement et l'étape d'aluminisation. Dans un mode de réalisation non limitatif, lesdites billes sont constituées de nickel.

Dans un mode de réalisation non limitatif, le procédé comporte une étape de diffusion, suivant l'étape d'aluminisation. Cela permet d'éviter la formation d'une phase d'aluminium sur-stoechiométrique. En effet, une telle phase est fragile.

Dans un mode de réalisation non limitatif, le procédé comporte une étape de dépôt d'une couche favorisant l'aluminisation. Cette couche est destinée à favoriser le dépôt d'aluminium.

Dans un mode de réalisation non limitatif, la couche est obtenue par voie électrolytique, par exemple de platine ou de palladium.

Dans un mode de réalisation non limitatif, la couche est obtenue par un dépôt physique en phase vapeur.

Dans un mode de réalisation non limitatif, le procédé selon l'invention comporte une étape précédant l'étape de positionnement : un traitement de surface des première et deuxième surfaces. Cette préparation de surface est destinée à préparer et nettoyer la première et la deuxième surface afin de favoriser l'aluminisation.

Dans un mode de réalisation non limitatif, le traitement de surface comporte un dégraissage des première et deuxième surfaces à l'acétone sous agitation ultra sonore.

Dans un mode de réalisation non limitatif, le traitement de surface comporte une dissolution chimique des oxydes superficiels des métaux constituant les première et deuxième pâles.

Dans un mode de réalisation non limitatif, le procédé comporte une étape de masquage d'au moins une zone de la première pâle, précédant l'étape de positionnement. Cela permet d'éviter un dépôt d'aluminium sur certaines zones du distributeur, par exemple les pieds d'aubes.

Dans un mode de réalisation non limitatif, le procédé comporte une étape de détermination du jeu d'assemblage, précédent l'étape de positionnement. En effet, la couche liante d'aluminium ne doit pas être trop épaisse, pour éviter un abattement des propriétés mécaniques. On note que l'évolution de l'épaisseur déposée en fonction des paramètres de temps, température et pression, suit une loi parabolique. Le jeu d'assemblage est de l'ordre de quelques dizaines de micromètres.

L'invention et ses différentes applications seront mieux comprises à la lecture de la description qui suit et à l'examen des figures qui l'accompagnent.

### BREVE DESCRIPTION DES FIGURES

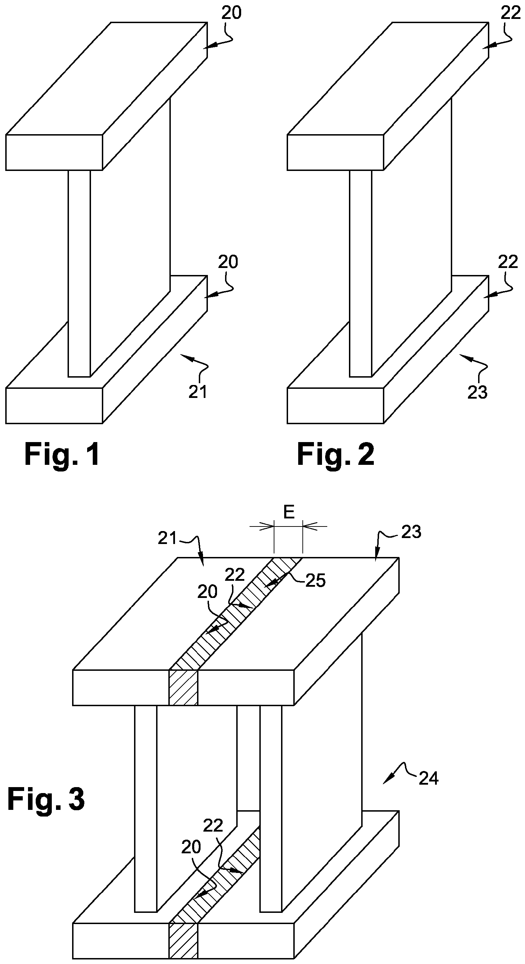

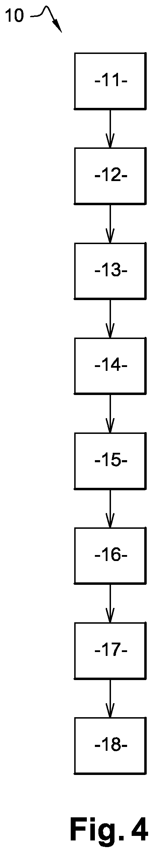

Les figures ne sont présentées qu'à titre indicatif et nullement limitatif de l'invention. Les figures montrent :
- A la figure 1, une représentation schématique d'une première pâle de distributeur
- A la figure 2, une représentation schématique d'une deuxième pâle de distributeur
- A la figure 3, une représentation schématique d'un distributeur formé de l'association de la première pâle de la figure 1 et la deuxième pâle de la figure 2
- A la figure 4, une représentation schématique des étapes d'un procédé d'assemblage selon un mode de réalisation non limitatif de l'invention.

### DESCRIPTION DETAILLEE D'AU MOINS UN MODE DE REALISATION DE L'INVENTION

Sauf précision contraire, un même élément apparaissant sur des figures différentes présente une référence unique.

En référence aux figures 1, 2 et 3, le procédé selon l'invention vise à assembler une première surface 20 d'une première pâle 21 et une deuxième surface 22 d'une deuxième pâle 23, afin de former un distributeur 24 de turbomachine, par exemple un distributeur de turbine haute pression utilisé sur des moteurs civils et militaires. Les alliages communément employés dans les turbines haute pression et basse pression sont des superalliages à base nickel. Cependant, le procédé selon l'invention est également applicable à des superalliages à base cobalt.

Le procédé met en oeuvre une étape d'aluminisation en phase vapeur, comme cela est détaillé ci-après.

En référence à la figure 4, le procédé 10 selon l'invention comporte les étapes suivantes :
- Selon une première étape 11, un masquage d'au moins une zone de la première pâle 21 et/ou d'une zone de la deuxième pâle 23. En effet, il est important de protéger certaines zones sensibles de l'aluminisation, par exemple un pied d'aube. On note que cette première étape est optionnelle : elle n'est pas présente dans un autre mode de réalisation de l'invention. Les masques utilisés sont des éléments métalliques recouvrant certaines zones et garantissant une étanchéité à l'aluminisation. Les masques classiquement utilisés dans l'art antérieur peuvent être utilisés car la température d'aluminisation en phase vapeur selon l'invention est équivalente à cette d'une aluminisation classique.
- Selon une deuxième étape 12, un traitement de surface de la première surface 20 et de la deuxième surface 22. Le traitement de surface sert à préparer les surfaces à assembler. Le traitement de surface comporte par exemple un simple dégraissage à l'acétone sous agitation ultra sonore, ou encore une dissolution chimique des oxydes superficiels des métaux constituant les première et deuxième pâles 21, 23. La dissolution chimique comporte un conditionnement des oxydes en bain alcalin, suivi d'une activation chimique sous acide, puis d'un blanchissement en bain alcalin. On note que cette deuxième étape est optionnelle : elle n'est pas présente dans un autre mode de réalisation de l'invention. On note également que dans un autre mode de réalisation, la deuxième étape 12 est réalisée avant la première étape 11.
- Selon une troisième étape 13, un dépôt d'une couche favorisant l'aluminisation. Le dépôt est par exemple obtenu par voie électrolytique de platine ou de palladium ou toute autre combinaison connue pour favoriser un dépôt d'aluminium. La couche peut également être déposée par un dépôt physique en phase vapeur, ou prendre la forme d'un feuillard. On note que la troisième étape est optionnelle : elle n'est pas présente dans un autre mode de réalisation de l'invention.
- Selon une quatrième étape 14, une détermination d'un jeu d'assemblage E, ledit jeu d'assemblage E correspondant à une distance séparant la première surface 20 de la première pâle 21 et la deuxième surface 22 de la deuxième pâle 23 lorsque lesdites première et deuxième surfaces sont positionnées en vis-à-vis afin de subir l'aluminisation. Le jeu d'assemblage E est déterminé en fonction du matériau constitutif des pâles, de la forme des pâles, des conditions du traitement d'aluminisation, etc. Le jeu d'assemblage E est de l'ordre de quelques dizaines de micromètres, il est par exemple compris entre trente et cent cinquante micromètres. Le jeu d'assemblage E est par exemple de quarante à cinquante micromètres, ce qui est un ordre de grandeur usuel retenu pour des opérations de brasage-diffusion pour des alliages à base nickel.
- Selon une cinquième étape 15, un positionnement en vis-à-vis de la première surface 20 de la première pâle 21 et de la deuxième surface 22 de la deuxième pâle 23, lesdites première et deuxième surfaces étant espacées l'une de l'autre du jeu d'assemblage E.
- Selon une sixième étape 16, une implantation de billes soudées dans les première et deuxième surfaces 20, 22, de sorte à maintenir le positionnement. Dans le cas de superalliages en base nickel, les billes sont constituées de nickel. Le nombre et l'espacement entre les billes dépend des formes des pâles à assembler. Cette technologie fonctionne en stockant le courant de soudure dans des condensateurs. La décharge des condensateurs libère le courant en une impulsion très rapide. Il est ainsi possible de produire des courants de soudure extrêmes de plusieurs 100 kA dans un laps de temps extrêmement court, ce qui permet dans le cas de billes en nickel de les faire fondre afin qu'elles maintiennent en position les surfaces avant assemblage.
- Selon une septième étape 17, une aluminisation par dépôt en phase vapeur des première et deuxième surfaces, de sorte à combler le jeu d'assemblage E. Cette étape comporte des sous-étapes suivantes :
   ∘ Un placement de l'ensemble formé de la première pâle 21, de la deuxième pâle 23, et des billes, dans une installation thermochimique. Dans cette installation thermochimique, appelée enceinte, circule un mélange gazeux comprenant un composé de l'aluminium, tel qu'un halogénure, et un gaz de dilution ou gaz porteur. L'halogénure est produit par réaction entre un halogène, par exemple à base de chlore et/ou de fluor, et un donneur métallique contenant de l'aluminium, par exemple un alliage métallique d'aluminium avec un ou plusieurs des constituants métalliques du matériau de la pièce à protéger. Dans un mode de réalisation de l'invention, le donneur métallique contenant de l'aluminium est de composition massique CrAl₂₀ ou CrAl₃₀. Dans un autre mode de réalisation de l'invention, le donneur est un cément ternaire ou quaternaire tel que décrit dans le document FR2950364. Dans ce cas, il est possible d'obtenir, en plus de l'aluminium, un dopage en éléments réactifs (tels que hafnium, zirconium...) connus comme bénéfiques pour la tenue à l'oxydation. Dans un mode de réalisation de l'invention, l'halogène est du fluor et l'halogénure produit est de composition NH₄F ou HF. Dans un mode de réalisation de l'invention, l'halogène est du chlore et l'halogénure produit est de composition NH₄Cl. Dans un mode de réalisation, le gaz de dilution utilisé est l'argon. Dans un mode de réalisation, la pression partielle d'argon dans l'enceinte est de l'ordre de 100mBar. Cette pression est avantageusement une limite basse. On note qu'il importe de trouver un compromis entre la pression partielle de gaz de dilution (en Bar), le volume utile de l'enceinte (en dm³), et la quantité d'halogénure (en grammes), afin d'optimiser l'aluminisation. Dans un mode de réalisation, les gammes opératoires sont comprises entre 10⁻² et 140 g/Bar/dm³. Plus précisément, dans un mode de réalisation, les gammes opératoires sont comprises entre 0.1 et 20 g/Bar/dm³.
   ∘ Un traitement thermique de l'ensemble dans l'enceinte. Dans un mode de réalisation dans lequel la troisième étape n'est pas réalisée, le traitement thermique est réalisé durant six heures à température de 1100 degrés Celsius. Dans un mode de réalisation dans lequel la troisième étape est réalisée, le traitement thermique est réalisé durant six heures à température de 1080 degrés Celsius. Ces conditions de température et de durée ne sont pas limitatives. Dans un autre mode de réalisation, la température est comprise entre 950 et 1200 degrés Celsius. Dans un autre mode de réalisation, la durée du traitement thermique est comprise entre deux et douze heures. A l'issu du traitement thermique, un dépôt 25 homogène d'aluminium est obtenu sur la première surface 20 et la deuxième surface 22, ledit dépôt 25 comblant le jeu d'assemblage E. Ainsi, grâce au dépôt 25, les deux pâles 21, 23 sont assemblées.
- Selon une huitième étape 18, un traitement de diffusion afin d'éviter la formation d'une phase d'aluminure de nickel en quantité sur-stoechiométrique, qui est fragile. Dans un mode de réalisation, le traitement de diffusion est réalisé sous vide, à température de 1100 degrés Celsius, pendant une durée d'une heure ou plus. On note que cette huitième étape est facultative, elle n'est pas présente dans un autre mode de réalisation de l'invention.

Le procédé consiste donc à assembler les pâles pendant la réalisation d'un revêtement d'aluminure de nickel. Ce type d'assemblage présente des caractéristiques intéressantes en termes de résistance mécanique et en termes de résistance à l'oxydation.

## Revendications

1. Procédé d'assemblage (10) de deux pâles de distributeur de turbomachine, comportant :
- Un positionnement (15) en vis-à-vis d'une première surface (20) d'une première pâle (21) et d'une deuxième surface (22) d'une deuxième pâle (23), lesdites première surface (20) et deuxième surfaces (22) étant espacées l'une de l'autre
- d'un jeu d'assemblage (E), et **caractérisé par** les étapes suivantes :
- Une implantation (16) de billes soudées dans les première surface (20) et deuxième surface (22), de sorte à maintenir le positionnement,
- Une aluminisation par dépôt en phase vapeur (17) des première surface (20) et deuxième surface (22), de sorte à combler le jeu d'assemblage (E).

2. Procédé d'assemblage (10) selon l'une des revendications précédentes, **caractérisé en ce qu'**il comporte une étape de diffusion (18), suivant l'étape d'aluminisation (17).

3. Procédé d'assemblage (10) selon l'une des revendications précédentes, **caractérisé en ce qu'**il comporte une étape de dépôt (13) d'une couche favorisant l'aluminisation, précédant l'étape de positionnement.

4. Procédé d'assemblage (10) selon la revendication précédente, **caractérisé en ce que** la couche est obtenue par voie électrolytique.

5. Procédé d'assemblage (10) selon la revendication 3, **caractérisé en ce que** la couche est obtenue par un dépôt physique en phase vapeur.

6. Procédé d'assemblage (10) selon l'une des revendications précédentes, comportant une étape de traitement de surface (12) des première surface (20) et deuxième surface (22), précédant l'étape de positionnement (15).

7. Procédé d'assemblage (10) selon la revendication précédente, **caractérisé en ce que** le traitement de surface (12) comporte un dégraissage des première surface (20) et deuxième surface (22) à l'acétone sous agitation ultra sonore.

8. Procédé d'assemblage (10) selon l'une des revendications précédentes, **caractérisé en ce qu'**il comporte une étape de masquage (11) d'au moins une zone de la première pâle (21), précédant l'étape de positionnement (15).

9. Procédé d'assemblage (10) selon l'une des revendications précédentes, **caractérisé en ce qu'**il comporte une étape de détermination (14) du jeu d'assemblage (E), précédent l'étape de positionnement (15).

## Patentansprüche

1. Montageverfahren (10) von zwei Turbomaschinen-Verteilerflügeln, umfassend:
- eine Positionierung (15) gegenüber einer ersten Oberfläche (20) eines ersten Flügels (21) und einer zweiten Oberfläche (22) eines zweiten Flügels (23), wobei die genannte erste Oberfläche (20) und zweite Oberfläche (22) voneinander durch ein Montagespiel (E) beabstandet sind und durch die folgenden Schritte gekennzeichnet sind:
- ein Einsetzen (16) von Kugeln, die in der ersten Oberfläche (20) und der zweiten Oberfläche (22) derart verschweißt sind, dass die Positionierung gehalten wird;
- einen Aluminierung per Aufbringen der ersten Oberfläche (20) und der zweiten Oberfläche (22) in der Dampfphase (17) derart, dass das Montagespiel (E) aufgefüllt wird.

2. Montageverfahren (10) gemäß irgendeinem der voranstehenden Ansprüche, **dadurch gekennzeichnet, dass** es einen Verteilerschritt (18) im Anschluss an den Aluminierungsschritt (17) umfasst.

3. Montageverfahren (10) gemäß einem der voranstehenden Ansprüche, **dadurch gekennzeichnet, dass** es einen Aufbringschritt (13) einer die Aluminierung begünstigenden Schicht vor dem Positionierungsschritt umfasst.

4. Montageverfahren (10) gemäß dem voranstehenden Anspruch, **dadurch gekennzeichnet, dass** die Schicht auf elektrolytischem Weg erhalten wird.

5. Montageverfahren (10) gemäß Anspruch 3, **dadurch gekennzeichnet, dass** die Schichte durch ein physisches Aufbringen in der Dampfphase erhalten wird.

6. Montageverfahren (10) gemäß einem der voranstehenden Ansprüche, umfassend einen Oberflächenbehandlungsschritt (12) der ersten Oberfläche (20) und der zweiten Oberfläche (22), der dem Positionierungsschritt (15) vorangeht.

7. Montageverfahren (10) gemäß dem voranstehenden Anspruch, **dadurch gekennzeichnet, dass** die Oberflächenbehandlung (12) eine Entfettung der ersten Oberfläche (20) und der zweiten Oberfläche (22) mit Aceton unter Ultraschallrütteln umfasst.

8. Montageverfahren (10) gemäß einem der voranstehenden Ansprüche, **dadurch gekennzeichnet, dass** es einen Abdeckschritt (11) wenigstens eines Bereichs des ersten Flügels (21) vor dem Positionierungsschritt (15) umfasst.

9. Montageverfahren (10) gemäß einem der voranstehenden Ansprüche, **dadurch gekennzeichnet, dass** es einen Bestimmungsschritt (14) des Montagespiels (E) vor dem Positionierungsschritt (15) umfasst.

## Claims

1. Method of assembly (10) of two turbomachine nozzle blades, comprising:
∘ Positioning (15) facing each other, of a first surface (20) of a first blade (21) and of a second surface (22) of a second blade (23), where said first surface (20) and second surfaces (22) are spaced apart from each other by a clearance (E), and **characterised by** the following steps:
∘ Implantation (16) of welded balls into the first surface (20) and second surface (22), so as to maintain the positioning,
∘ Aluminisation by vapour phase deposition (17) of the first surface (20) and second surface (22), so as to fill in the clearance (E).

2. Method of assembly (10) according to the preceding claim, **characterised in that** it comprises a diffusion step (18) and following the aluminisation step (17).

3. Method of assembly (10) according to any of the preceding claims, **characterised in that** it comprises a step (13) for deposition of a layer which favours the aluminisation, preceding the positioning step.

4. Method of assembly (10) according to the preceding claim, **characterised in that** the layer is obtained using an electrolytic path.

5. Method of assembly (10) according to claim 3, **characterised in that** the layer is obtained by physical deposition in the vapour phase.

6. Method of assembly (10) according to any of the preceding claims, comprising a surface treatment step (12) of the first surface (20) and second surface (22), which precedes the positioning step (15).

7. Method of assembly (10) according to the preceding claim, **characterised in that** the surface treatment (12) comprises degreasing of the first surface (20) and second surface (22) with acetone using ultrasonic agitation.

8. Method of assembly (10) according to any of the preceding claims, **characterised in that** it comprises a step (11) for masking at least one zone of the first blade (21) and preceding the positioning step (15).

9. Method of assembly (10) according to any of the preceding claims, **characterised in that** it comprises a step (14) for determination of the clearance (E) and preceding the positioning step (15).
